# EUROPEAN PATENT APPLICATION

(11) **EP 4 468 336 A1**
(43) Date of publication of application: **27.11.2024**
(21) Application number: 23206612.6
(22) Date of filing: 30.10.2023
(51) Int. Cl.: H01L 23/433, H01L 21/56, H01L 25/065

(54) **HEAT DISSIPATION SOLUTIONS FOR INTEGRATED CIRCUIT PACKAGES**

(30) Priority: 26.05.2023 US 202318324640
(71) Applicant: INTEL Corporation, Santa Clara, CA 95054 (US)
(72) Inventor: Tsarfati, Avi, 4970602 Petah Tikva (IL); O'Sullivan, David, 85521 Ottobrunn (DE); Prasad, Vishnu, 81737 Munich (DE); Wagner, Thomas, 91189 Rohr (DE); Manoharan, Aruna, Gilbert, 85295 (US)
(74) Representative: Goddar, Heinz J.

(57) **Abstract**

In one embodiment, an integrated circuit package includes a package substrate, a first integrated circuit die electrically coupled to the package substrate via wire bond connectors, and a second integrated circuit die coupled to the package substrate. The package further includes a heat spreader coupled to the first integrated circuit die via a thermal interface material (TIM) and a dielectric material encompassing the first integrated circuit die and the second integrated circuit die on the package substrate. A top surface of the heat spreader is aligned with a top surface of the dielectric material.

## Description

### BACKGROUND

Integrated circuit packages may utilize a heat sink or integrated heat spreader that is coupled to the package. Modern integrated circuit packages may implement dies with different assembly technologies (e.g., flip chip and wire bond). When using a wire bond-based die together with flip chip-based die, a mold may encapsulate both dies on the package, and current systems may utilize a heat sink with a thermal interface material (TIM) above the molded package. However, this solution provides limited heat dissipation from the dies due to the low thermal conductivity of the mold compound, since the mold compound effectively locks the heat inside the package due to its low thermal conductivity.

### BRIEF DESCRIPTION OF THE DRAWINGS

FIG. 1 illustrates an example multi-chip integrated circuit package with a traditional heat dissipation solution.
FIGS. 2A-2B illustrate example multi-chip integrated circuit packages incorporating a heat dissipation solution in accordance with certain embodiments.
FIGS. 3A-3B illustrate example multi-chip integrated circuit packages incorporating other heat dissipation solutions in accordance with certain embodiments.
FIGS. 4A-4B illustrate example multi-chip integrated circuit packages incorporating another heat dissipation solution in accordance with certain embodiments.
FIGS. 5A-5B illustrate example multi-chip integrated circuit packages incorporating still another other heat dissipation solution in accordance with certain embodiments.
FIGS. 6A-6B illustrate an example process of forming a multi-chip integrated circuit package with heat dissipation solutions in accordance with certain embodiments.
FIG. 7 is a top view of a wafer and dies that may be included in a microelectronic assembly, in accordance with any of the embodiments disclosed herein.
FIG. 8 is a cross-sectional side view of an integrated circuit device assembly that may include embodiments disclosed herein.
FIG. 9 is a cross-sectional side view of an integrated circuit device that may be included in a microelectronic assembly, in accordance with any of the embodiments disclosed herein.
FIG. 10 is a block diagram of an example electrical device that may include a microelectronic assembly, in accordance with any of the embodiments disclosed herein.

### DETAILED DESCRIPTION

Embodiments herein provide various heat dissipation solutions for integrated circuit packages, such as, for example, a flip chip chip-scale package (FCCSP) that includes multiple integrated circuit dies. Typically, integrated circuit packages utilize a heat sink or integrated heat spreader that is coupled to the package. Modern integrated circuit packages may implement dies with different assembly technologies (e.g., flip chip and wire bond) that each require assembly-compatible thermal solutions. When using a wire bond-based die together with flip chip-based die, a mold may encapsulate both dies on the package, and current systems may utilize a heat sink with a thermal interface material (TIM) above the molded package. However, this solution provides limited heat dissipation from the dies due to the low thermal conductivity of the mold compound, since the mold compound effectively locks the heat inside the package due to its low thermal conductivity. This is true even when using more advanced, highly conductive mold compounds, e.g., those with thermal conductivities upwards of 3 W/mK.

The present disclosure describes techniques for improving thermal management in integrated circuit packages, such those that include mixed assembly technologies, e.g., a package that includes both a flip chip-based die and a wire bond-based die. For example, certain embodiments may combine several technologies by adding thermal conductive elements into the package to allow better heat dissipation to a heat sink above the package. Achieving high power and hybrid packages in small form factors is the key to future development of computing devices. The thermal conductivity of novel materials and heat transfer solutions do not suffice for the growing industry standards. The heat dissipation solutions described herein may allow for the development of hybrid packages (those with dies having different attachment technologies) with efficient heat dissipation, thus resulting in low loss and high product efficiency.

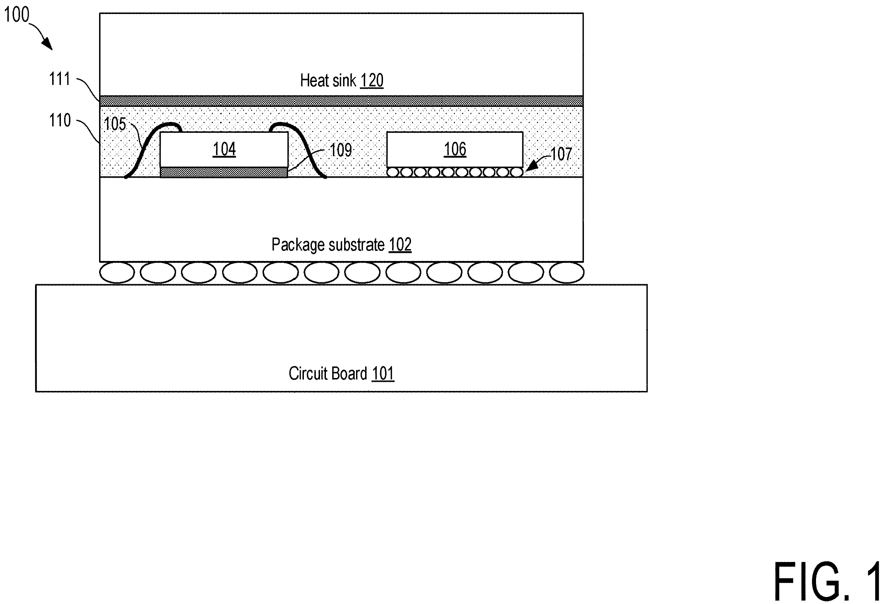

FIG. 1 illustrates an example multi-chip integrated circuit package 100 with a traditional heat dissipation solution. The package 100 includes a package substrate 102 coupled to a main circuit board 101. The package 100 includes a first integrated circuit die 104 and a second integrated circuit die 106 coupled to the package substrate 102. The package substrate 102 may include circuitry to connect the dies 104, 106 to the main circuit board 101 (which may be, e.g., a motherboard or main board of a computing system) and/or to interconnect the dies 104, 106 with one another. For example, the package substrate 102 may include connections for signaling between the main circuit board and the dies 104 and/or 106, as well as connections for providing power delivery from the main circuit board (e.g., from a power supply coupled to the main circuit board) to the dies 104 and/or 106. Further, in some embodiments, the package substrate 102 may include interconnect bridge circuitry that interconnects the dies 104, 106. The bridge circuitries may be implemented, in certain instances, as dies that are embedded within the package substrate 102. However, other embodiments may implement the interconnect bridge circuitry as circuitry within upper layers of the package substrate 102. The interconnect bridge circuitries may include any suitable passive and/or active circuitry to interconnect the first dies 104 with the second die 106. An example implementation of an interconnect bridge circuitry is an Intel^{®} Embedded Multi-Die Interconnect Bridge (EMIB) die.

In the example shown, the first die 104 is implemented with wire bond electrical connections 105 to the package substrate 102, while the second die 106 is implemented with flip chip solder ball connections 107 to the package substrate 102, which may include solder balls coupled between conductive pads on a lower surface of the die 106 and conductive pads on an upper surface of the package substrate 102. The package 100 may include other integrated circuit dies, which may implement either wire bond or solder ball-based connections with the package substrate 102. Between the die 104 and the package substrate 102, there is a thermal interface material (TIM) 109 that is thermally conductive (e.g., to aid in conducting heat from the die 104). In other embodiments, any suitable material for a die attachment process may be used in lieu of or in addition to TIM 109. The dies 104, 106 are encapsulated with a dielectric mold material 110 as shown. The package 100 also includes a heat sink 120 attached to the dielectric mold material 110 via another TIM 111 as shown. The heat sink 120 may serve as the primary heat dissipation means for the package 100.

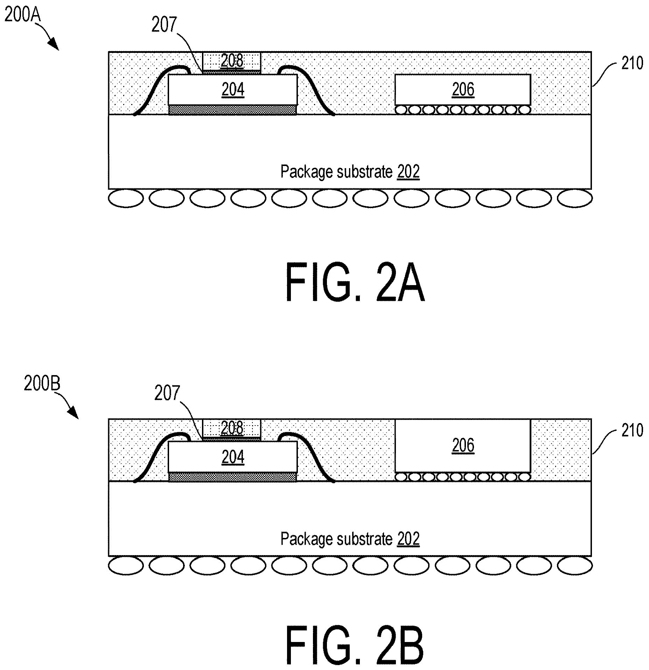

FIGS. 2A-2B illustrate example multi-chip integrated circuit packages 200A, 200B incorporating a heat dissipation solution in accordance with certain embodiments. The example packages 200A, 200B include a package substrate 202, which may be the same or similar as the package substrate 102 of FIG. 1, with dies 204 and 206 coupled to the package substrate 202. The dies 204 and 206 are similar to the dies 104 and 106 of FIG. 1, respectively. That is, the die 204 is implemented with wire bond electrical connections to the package substrate 202 like the die 104, while the second die 206 is implemented with flip chip solder ball connections to the package substrate 202 like the die 106. Although not shown, the packages 200 may be connected to a main circuit board, e.g., the circuit board 101 of FIG. 1, in a similar manner as the package 100 of FIG. 1. In addition, although not shown, the packages 200 may be implemented with a heat sink (e.g., 120 of FIG. 1) or other type of heat dissipation solution (e.g., liquid-based cooling element, heat exchanger, etc.) above the packages 200, similar to the package 100 of FIG. 1.

In each of the examples shown in FIG. 2A and 2B, the die 204 includes a heat spreader 208 above it, with a TIM 207 between the die 204 and the heat spreader 208. The heat spreader 208 may include any suitable thermally conductive material, such as a metal (e.g., Copper). A top surface of the heat spreader 208 is exposed at a top surface of the package 200A, 200B. That is, the top surface of the heat spreader 208 is aligned with the top surface of the overall molded package 200A, 200B. The heat spreader 208 can thus be in contact with a heat sink or other type of package-level heat spreader that would be attached to the top of the package 200A, 200B, which would allow for better thermal conductivity from the die 204 to the heat sink/heat spreader.

In the example shown in FIG. 2A, the die 206 of the package 200A has the dielectric mold material 210 between its top surface and the top surface of the package 200A. However, in the example shown in FIG. 2B, the die 206 is enlarged so that its top surface is exposed at the top surface of the package 200B similar to the heat spreader 208. This can allow for better thermal conductivity between the die 206 and a heat sink/package-level heat spreader that would be attached to the top of the package 200B.

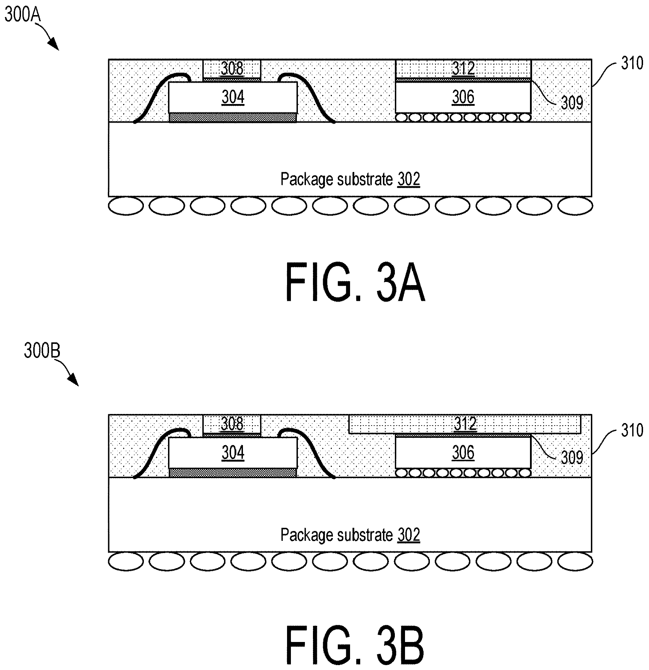

FIGS. 3A-3B illustrate example multi-chip integrated circuit packages 300A, 300B incorporating other heat dissipation solutions in accordance with certain embodiments. The example packages 300A, 300B include a package substrate 302, which may be the same or similar as the package substrate 102 of FIG. 1, with dies 304 and 306 coupled to the package substrate 302. The dies 304 and 306 are similar to the dies 104 and 106 of FIG. 1, respectively, and dies 204 and 206 of FIGS. 2A and 2B, respectively. That is, the die 304 is implemented with wire bond electrical connections to the package substrate 302, while the second die 306 is implemented with flip chip solder ball connections to the package substrate 302. Although not shown, the packages 300 may be connected to a main circuit board, e.g., the circuit board 101 of FIG. 1, in a similar manner as the package 100 of FIG. 1. In addition, although not shown, the packages 300 may be implemented with a heat sink (e.g., 120 of FIG. 1) or other type of heat dissipation solution (e.g., liquid-based cooling element, heat exchanger, etc.) above the packages 300, similar to the package 100 of FIG. 1.

In each of the examples shown in FIG. 3A and 3B, the die 304 includes a heat spreader 308 above it, with a TIM between the die 304 and the heat spreader 308. The heat spreader 308 may include any suitable thermally conductive material, such as a metal (e.g., Copper). A top surface of the heat spreader 308 is exposed at a top surface of the package 300A, 300B. That is, the top surface of the heat spreader 308 is aligned with the top surface of the overall molded package 300A, 300B. The heat spreader 308 can thus be in contact with a heat sink or other type of package-level heat spreader that would be attached to the top of the package 300A, 300B, which would allow for better thermal conductivity from the die 304 to the heat sink/heat spreader.

In addition, in each of the examples shown, the die 306 includes a heat spreader 312 above it, with a TIM 309 between the die 306 and the heat spreader 312. The heat spreader 312 may include any suitable thermally conductive material, such as a metal (e.g., Copper). A top surface of the heat spreader 312 is exposed at a top surface of the package 300A, 300B. That is, the top surface of the heat spreader 312 is aligned with the top surface of the overall molded package 300A, 300B. The heat spreader 312 can thus be in contact with a heat sink or other type of package-level heat spreader that would be attached to the top of the package 300A, 300B, which would allow for better thermal conductivity from the die 306 to the heat sink/heat spreader. The heat spreader 312 in FIG. 3A is the same width as the die 306, while the heat spreader 312 in FIG. 3B is wider than the die 306, which may aid in providing additional thermal conductivity to a heat sink/package-level heat spreader above the package 300B.

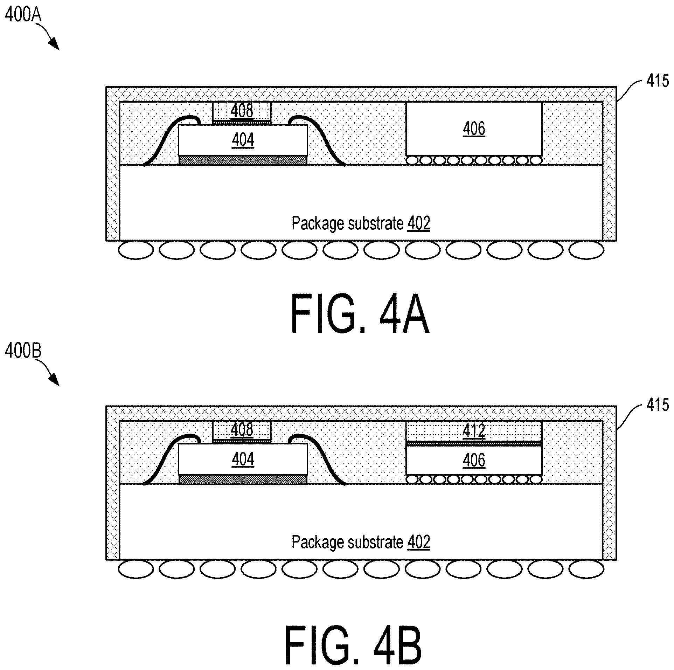

FIGS. 4A-4B illustrate example multi-chip integrated circuit packages 400A, 400B incorporating another heat dissipation solution in accordance with certain embodiments. The example packages 400A, 400B include a package substrate 402, which may be the same or similar as the package substrate 102 of FIG. 1, with dies 404 and 406 coupled to the package substrate 402. The dies 404 and 406 are similar to the dies 104 and 106 of FIG. 1, respectively, and dies 204 and 206 of FIGS. 2A and 2B, respectively. That is, the die 404 is implemented with wire bond electrical connections to the package substrate 402, while the second die 406 is implemented with flip chip solder ball connections to the package substrate 402. Although not shown, the packages 400 may be connected to a main circuit board, e.g., the circuit board 101 of FIG. 1, in a similar manner as the package 100 of FIG. 1. In addition, although not shown, the packages 400 may be implemented with a heat sink (e.g., 120 of FIG. 1) or other type of heat dissipation solution (e.g., liquid-based cooling element, heat exchanger, etc.) above the packages 400, similar to the package 100 of FIG. 1.

In each of the examples shown in FIG. 4A and 4B, the die 404 includes a heat spreader 408 above it, with a TIM between the die 404 and the heat spreader 408. The heat spreader 408 may include any suitable thermally conductive material, such as a metal (e.g., Copper). A top surface of the heat spreader 408 is exposed at a top surface of the package 400A, 400B. That is, the top surface of the heat spreader 408 is aligned with the top surface of the overall molded package 400A, 400B. The heat spreader 408 can thus be in contact with a heat sink or other type of package-level heat spreader that would be attached to the top of the package 400A, 400B, which would allow for better thermal conductivity from the die 404 to the heat sink/heat spreader.

In the example shown in FIG. 4A, a top surface of the die 406 is exposed at the top surface of the package 400A similar to the heat spreader 408. This can allow for better thermal conductivity between the die 406 and a heat sink/package-level heat spreader that would be attached to the top of the package 400A. In the example shown in FIG. 4B, the die 406 includes a heat spreader 412 above it, with a TIM between the die 406 and the heat spreader 412. The heat spreader 412 may include any suitable thermally conductive material, such as a metal (e.g., Copper). A top surface of the heat spreader 412 is exposed at a top surface of the package 400B. That is, the top surface of the heat spreader 412 is aligned with the top surface of the overall molded package 400B. The heat spreader 412 can thus be in contact with a heat sink or other type of package-level heat spreader that would be attached to the top of the package 400B, which would allow for better thermal conductivity from the die 406 to the heat sink/heat spreader.

In addition, in each example shown, the packages 400A, 400B include a thermally conductive material 415 conformally on an outer surface of the package to further promote thermal conductivity from the dies 404, 406 or other portions or components of the package, e.g., to a package-level heat spreader that would be above the package 400A, 400B. The thermally conductive material 415 any material with low thermal resistance/high thermal conductivity, e.g., a metal such as Copper or alloys. The material 415 may be sputtered onto the package, in certain embodiments.

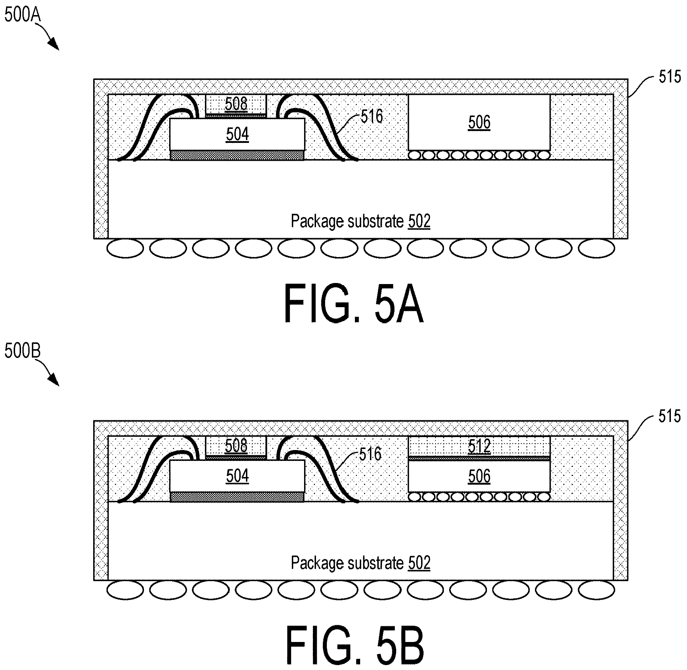

FIGS. 5A-5B illustrate example multi-chip integrated circuit packages 500A, 500B incorporating still another other heat dissipation solution in accordance with certain embodiments. The example packages 500A, 500B include a package substrate 502, which may be the same or similar as the package substrate 102 of FIG. 1, with dies 504 and 506 coupled to the package substrate 502. The dies 504 and 506 are similar to the dies 104 and 106 of FIG. 1, respectively, and dies 204 and 206 of FIGS. 2A and 2B, respectively. That is, the die 504 is implemented with wire bond electrical connections to the package substrate 502, while the second die 506 is implemented with flip chip solder ball connections to the package substrate 502. Although not shown, the packages 500 may be connected to a main circuit board, e.g., the circuit board 101 of FIG. 1, in a similar manner as the package 100 of FIG. 1. In addition, although not shown, the packages 500 may be implemented with a heat sink (e.g., 120 of FIG. 1) or other type of heat dissipation solution (e.g., liquid-based cooling element, heat exchanger, etc.) above the packages 500, similar to the package 100 of FIG. 1.

In each of the examples shown in FIG. 5A and 5B, the die 504 includes a heat spreader 508 above it, with a TIM between the die 504 and the heat spreader 508. The heat spreader 508 may include any suitable thermally conductive material, such as a metal (e.g., Copper). A top surface of the heat spreader 508 is exposed at a top surface of the package 500A, 500B. That is, the top surface of the heat spreader 508 is aligned with the top surface of the overall molded package 500A, 500B. The heat spreader 508 can thus be in contact with a heat sink or other type of package-level heat spreader that would be attached to the top of the package 500A, 500B, which would allow for better thermal conductivity from the die 504 to the heat sink/heat spreader.

In the example shown in FIG. 5A, a top surface of the die 506 is exposed at the top surface of the package 500A similar to the heat spreader 508. This can allow for better thermal conductivity between the die 506 and a heat sink/package-level heat spreader that would be attached to the top of the package 500A. In the example shown in FIG. 5B, the die 506 includes a heat spreader 512 above it, with a TIM between the die 506 and the heat spreader 512. The heat spreader 512 may include any suitable thermally conductive material, such as a metal (e.g., Copper). A top surface of the heat spreader 512 is exposed at a top surface of the package 500B. That is, the top surface of the heat spreader 512 is aligned with the top surface of the overall molded package 500B. The heat spreader 512 can thus be in contact with a heat sink or other type of package-level heat spreader that would be attached to the top of the package 500B, which would allow for better thermal conductivity from the die 506 to the heat sink/heat spreader.

In addition, in each example shown, the packages 500A, 500B include a thermally conductive material 515 conformally on an outer surface of the package to further promote thermal conductivity from the dies 504, 506 or other portions or components of the package, e.g., to a package-level heat spreader that would be above the package 500A, 500B. The thermally conductive material 515 may include any material with low thermal resistance/high thermal conductivity, e.g., a metal such as Copper or alloys. The material 515 may be sputtered onto the package, in certain embodiments. Further, in example shown, the die 504 includes certain wire bond connections 516 (e.g., ground connections for the die 504) that are in contact with the thermally conductive material 515. Other embodiments may not include the thermally conductive material 515, and such embodiments might have the wire bond connections 516 exposed at the top surface such that they are in contact with a package-level heat spreader, e.g., a heat sink such as heat sink 120 of FIG. 1. These embodiments can further promote thermal conductivity between the die 504 and a package-level heat spreader that could be attached to the package 500A, 500B.

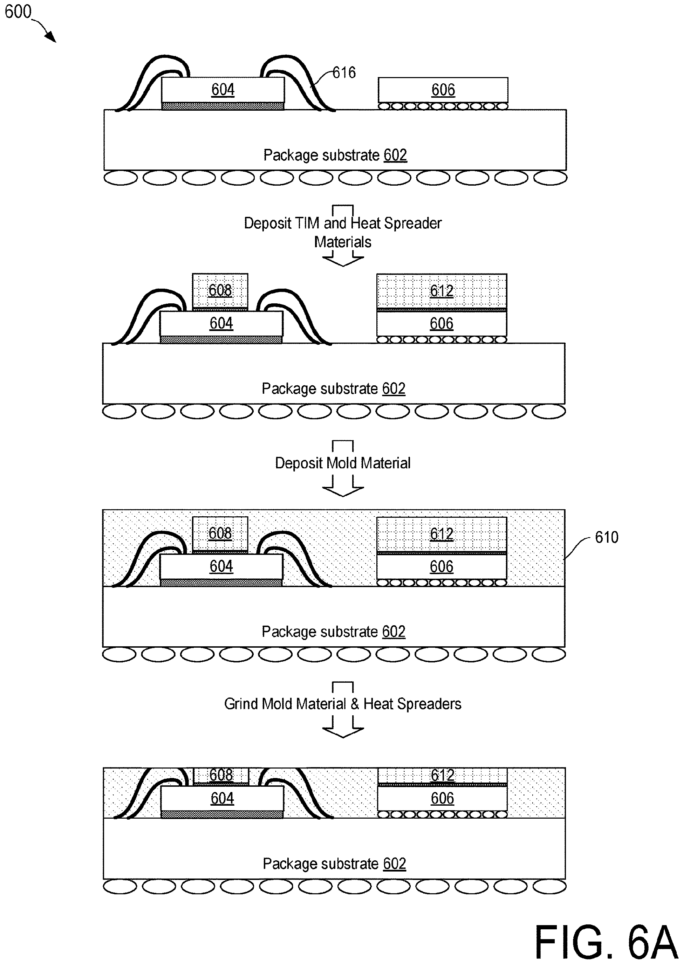

FIGS. 6A-6B illustrate an example process 600 of forming a multi-chip integrated circuit package with heat dissipation solutions in accordance with certain embodiments. The process 600 begins with an integrated circuit package that includes a package substrate 602 having dies 604, 606 coupled thereto. The package substrate 602 may be implemented in the same or similar manner as the package substrate 102 of FIG. 1, and the dies 604 and 606 may be implemented in the same or similar manner as the dies 104 and 106 of FIG. 1, respectively. That is, the die 604 is implemented with wire bond electrical connections to the package substrate 602, while the second die 606 is implemented with flip chip solder ball connections to the package substrate 602. The wire bond connections of the die 604 include a certain subset of connectors 616 (e.g., ground signal connectors) that are raised above other of the wire bond connectors to the die 604.

The process 600 includes depositing a TIM material on each of the dies 604, 606 and then a heat spreader material 608, 612 on the TIM on the dies 604, 606, respectively. The heat spreader materials may be any suitable thermally conductive material, and may be, in certain embodiments a metal such as Copper or an alloy. Next, a dielectric mold material 610 is deposited on the package to encapsulate and secure the dies 604, 606 to the package. The mold material 610 is deposited in the example shown such that the top surfaces of the heat spreader materials 608, 612 are not exposed. Next, the mold material 610 (and possibly a portion of the heat spreader materials 608, 612) is ground to expose a top surface of the heat spreader materials 608, 612 as shown in FIG. 6A. In the example shown, the mold material 610 and heat spreader materials 608, 612 are ground down. In certain embodiments, such as the example shown, the grinding may expose the subset of wire bond connectors 616 that are raised above the other wire bond connectors of the die 604, e.g., ground down far enough that the electrical connection between the die 604 and the package substrate 602 is disconnected. This can allow the wire bond connectors 616 to be in electrical and thermal connection with the conformal layer of thermally conductive material 615 (e.g., a metal such as Copper or an alloy) that is then deposited. The wire bond connectors 616 may be deposited using a sputtering process in certain embodiments, Next, a heat sink 620 or other type of package-level heat spreader apparatus is attached to the package. Finally, the package is attached to a main circuit board 601, e.g., a main circuit board or motherboard of a computing device.

Although particular example steps or operations are described with respect to the process 600, the process may include additional, fewer, or other steps than those disclosed. For instance, in some embodiments, a heat spreader material 612 may not be used above the die 606 (e.g., as shown in the packages of FIGS. 2A-2B, 4A, and 5A). As another example, a package may not include raised wire bond connectors such as the connectors 616 (e.g., as shown in the packages of FIGS. 2A-2B, 3A-3B, and 4A-4B).

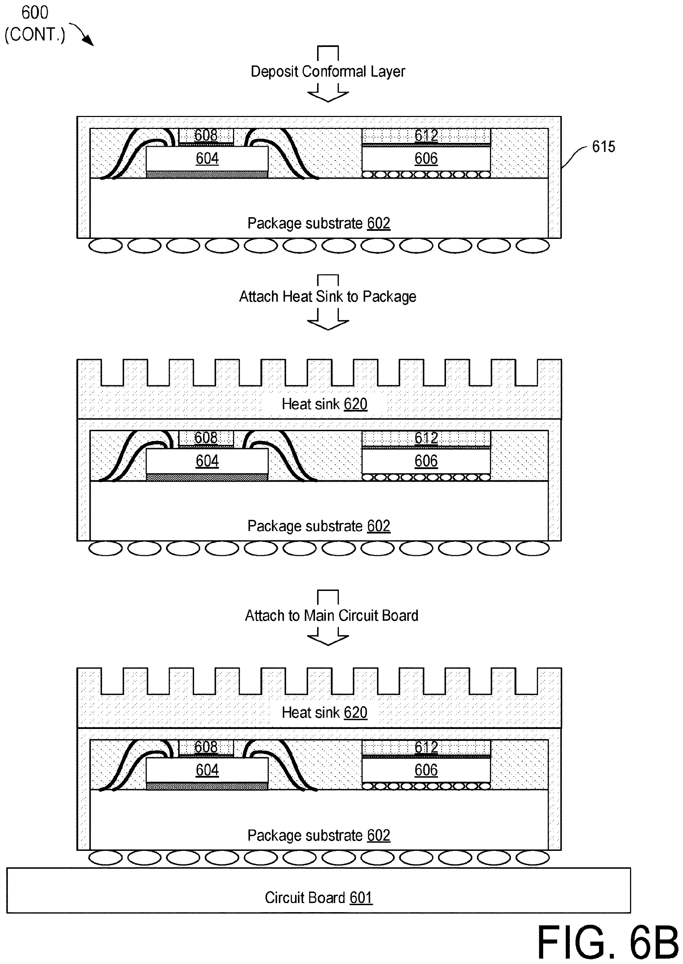

A simulation for was performed for various embodiments of the present disclosure to determine their heat dissipation capabilities. The simulation assumed an integrated circuit package according to many of the embodiments described above, but with two wire bond-based dies (e.g., 204, 304, 404, 506) and one flip chip-based die (e.g., 206, 306, 406, 506) on the package. Each wire bond die was assumed to have a 1W power consumption, while the flip chip die was assumed to have a 2W power consumption (a 4W total for the package). The package was assumed to have a package-level heat sink similar to 120 of FIG. 1 or 620 of FIG. 6B and an ambient temperature around the heat sink of 85°C. Table 1 below shows the simulation results for each example simulated using the above assumptions.

**Table 1**

| Example (the package of FIG. X) | Tj, max, Flip Chip Die (°C) | Tj, max, Wire Bond Die 1 (°C) | Tj, max, Wire Bond Die 2 (°C) |
|---|---|---|---|
| FIG. 1 | 125.9 | 142.6 | 140.7 |
| FIG. 2A | 125 | 130.4 | 128.7 |
| FIG. 2B | 117.5 | 129.2 | 127.8 |
| FIG. 3A | 118.3 | 129.3 | 127.9 |
| FIG. 3B | 113.7 | 128.7 | 127.4 |
| FIG. 4A | 115 | 122.3 | 121 |
| FIG. 5A | 115.1 | 119 | 117.7 |

Tables 2 and 3 below show additional simulation results to determine a maximum power consumption for the flip chip die and the second wire bond die shown above, respectively, assuming a maximum junction temperature for the clip chip die of 125°C and maximum junction temperature for the wire bond die of 150°C.

**Table 2**

| Example (the package of FIG. X) | Tj, max | Rth, Flip Chip Die | Max. Power at Tj, max | Gain from FIG. 1 | Gain from FIG. 2A |
|---|---|---|---|---|---|
| Baseline | 125.9 | 20.45 | 2.0 | | |
| Case 1 | 125 | 20 | 2.0 | 2% | |
| Case 2 | 117.5 | 16.25 | 2.5 | 26% | 23% |
| Case 3 | 118.3 | 16.65 | 2.4 | 23% | 20% |
| Case 3a | 113.7 | 14.35 | 2.8 | 43% | 39% |
| Case 2a | 115 | 12.8 | 3.1 | 36% | 33% |
| Case 2b | 115.1 | 12.75 | 3.1 | 36% | 33% |

**Table 3**

| Example (the package of FIG. X) | Tj, max | Rth, Wire Bond Die 2 | Max. Power at Tj, max | Gain from FIG. 1 | Gain from FIG. 2A |
|---|---|---|---|---|---|
| Baseline | 140.7 | 55.7 | 1.2 | | |
| Case 1 | 128.7 | 43.7 | 1.5 | 27% | |
| Case 2 | 127.8 | 42.8 | 1.5 | 30% | 2% |
| Case 3 | 127.9 | 42.9 | 1.5 | 30% | 2% |
| Case 3a | 127.4 | 42.4 | 1.5 | 31% | 3% |
| Case 2a | 121 | 36 | 1.8 | 55% | 21% |
| Case 2b | 117.7 | 32.7 | 2.0 | 70% | 34% |

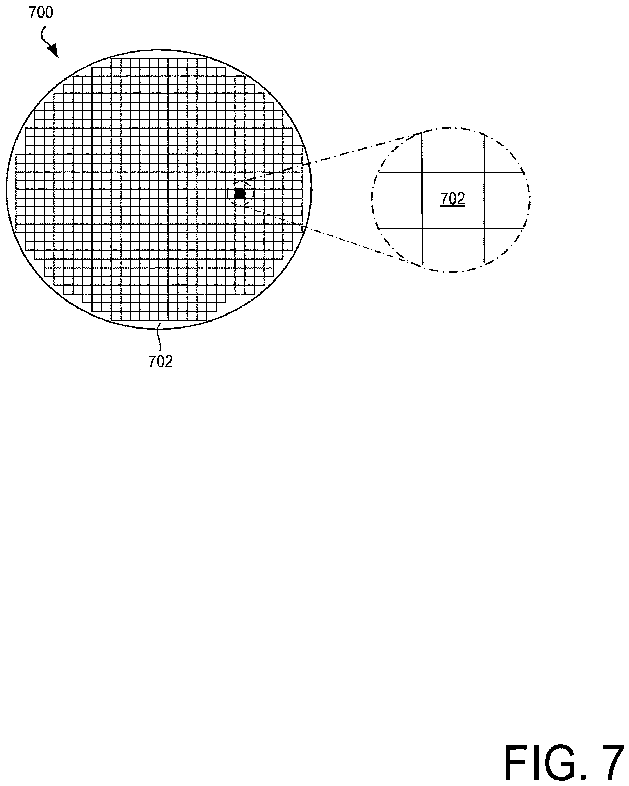

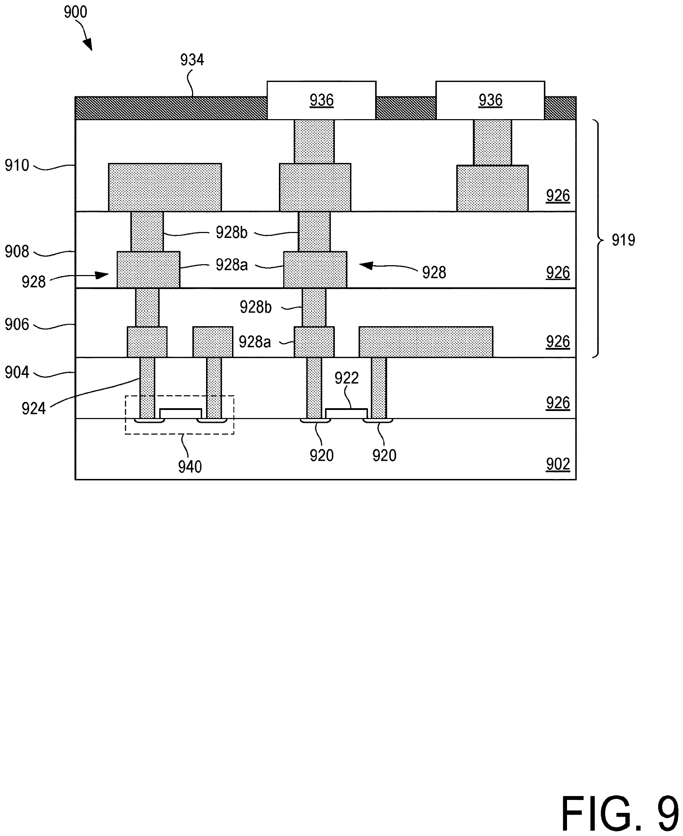

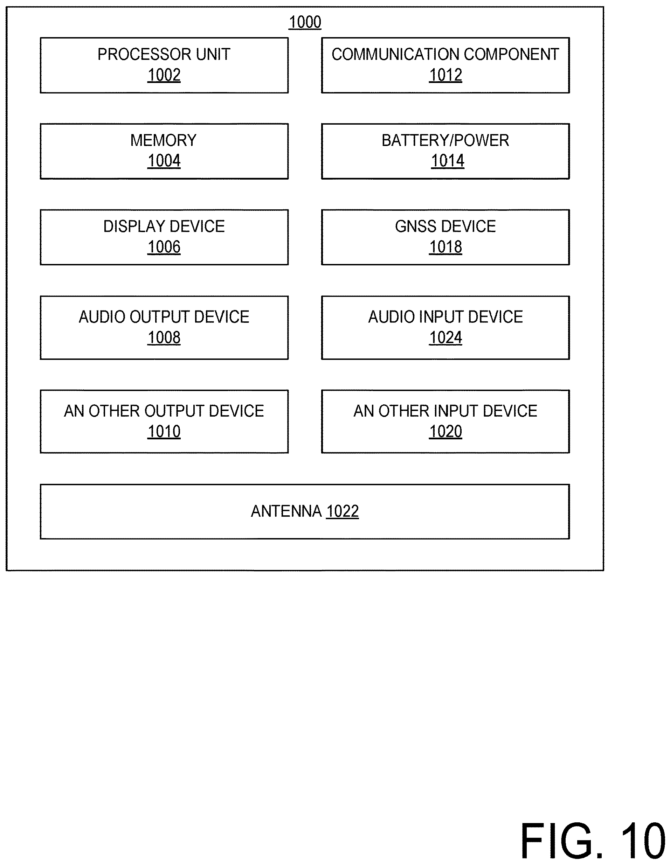

FIG. 7 is a top view of a wafer 700 and dies 702 that may be implemented in or along with any of the embodiments disclosed herein. The wafer 700 may be composed of semiconductor material and may include one or more dies 702 having integrated circuit structures formed on a surface of the wafer 700. The individual dies 702 may be a repeating unit of an integrated circuit product that includes any suitable integrated circuit. After the fabrication of the semiconductor product is complete, the wafer 700 may undergo a singulation process in which the dies 702 are separated from one another to provide discrete "chips" of the integrated circuit product. The die 702 may include one or more transistors (e.g., some of the transistors 940 of FIG. 9, discussed below), supporting circuitry to route electrical signals to the transistors, passive components (e.g., signal traces, resistors, capacitors, or inductors), and/or any other integrated circuit components. In some embodiments, the wafer 700 or the die 702 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 702. For example, a memory array formed by multiple memory devices may be formed on a same die 702 as a processor unit (e.g., the processor unit 1002 of FIG. 10) or other logic that is configured to store information in the memory devices or execute instructions stored in the memory array.

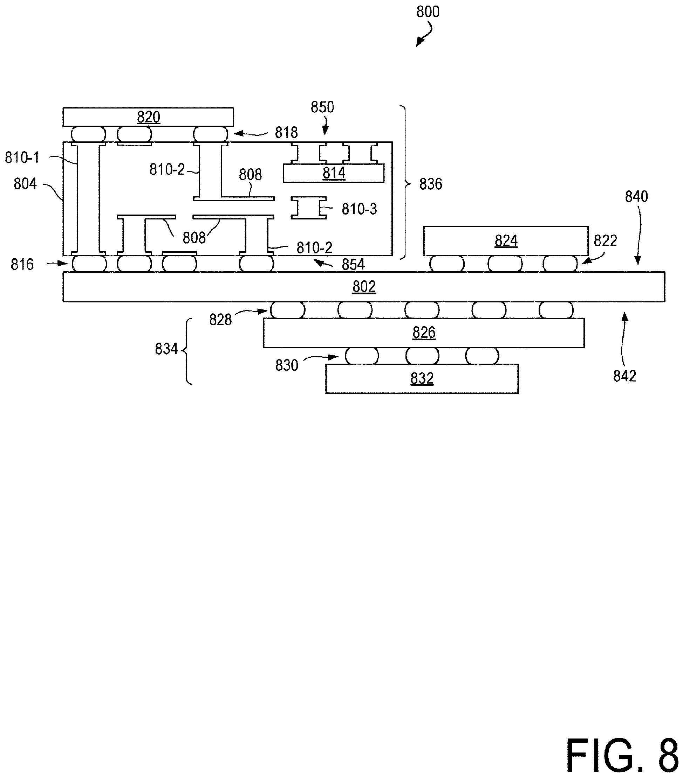

FIG. 8 is a cross-sectional side view of an integrated circuit device assembly 800 that may include any of the embodiments disclosed herein. The integrated circuit device assembly 800 includes a number of components disposed on a circuit board 802 (which may be a motherboard, system board, mainboard, etc.). The integrated circuit device assembly 800 includes components disposed on a first face 840 of the circuit board 802 and an opposing second face 842 of the circuit board 802; generally, components may be disposed on one or both faces 840 and 842.

In some embodiments, the circuit board 802 may be a printed circuit board (PCB) including multiple metal (or interconnect) layers separated from one another by layers of dielectric material and interconnected by electrically conductive vias. The individual metal layers comprise conductive traces. Any one or more of the metal layers may be formed in a desired circuit pattern to route electrical signals (optionally in conjunction with other metal layers) between the components coupled to the circuit board 802. In other embodiments, the circuit board 802 may be a non-PCB substrate. The integrated circuit device assembly 800 illustrated in FIG. 8 includes a package-on-interposer structure 836 coupled to the first face 840 of the circuit board 802 by coupling components 816. The coupling components 816 may electrically and mechanically couple the package-on-interposer structure 836 to the circuit board 802, and may include solder balls (as shown in FIG. 8), pins (e.g., as part of a pin grid array (PGA), contacts (e.g., as part of a land grid array (LGA)), male and female portions of a socket, an adhesive, an underfill material, and/or any other suitable electrical and/or mechanical coupling structure.

The package-on-interposer structure 836 may include an integrated circuit component 820 coupled to an interposer 804 by coupling components 818. The coupling components 818 may take any suitable form for the application, such as the forms discussed above with reference to the coupling components 816. Although a single integrated circuit component 820 is shown in FIG. 8, multiple integrated circuit components may be coupled to the interposer 804; indeed, additional interposers may be coupled to the interposer 804. The interposer 804 may provide an intervening substrate used to bridge the circuit board 802 and the integrated circuit component 820.

The integrated circuit component 820 may be a packaged or unpacked integrated circuit product that includes one or more integrated circuit dies (e.g., the die 702 of FIG. 7, the integrated circuit device 900 of FIG. 9) and/or one or more other suitable components. A packaged integrated circuit component comprises one or more integrated circuit dies mounted on a package substrate with the integrated circuit dies and package substrate encapsulated in a casing material, such as a metal, plastic, glass, or ceramic. In one example of an unpackaged integrated circuit component 820, a single monolithic integrated circuit die comprises solder bumps attached to contacts on the die. The solder bumps allow the die to be directly attached to the interposer 804. The integrated circuit component 820 can comprise one or more computing system components, such as one or more processor units (e.g., system-on-a-chip (SoC), processor core, graphics processor unit (GPU), accelerator, chipset processor), I/O controller, memory, or network interface controller. In some embodiments, the integrated circuit component 820 can comprise one or more additional active or passive devices such as capacitors, decoupling capacitors, resistors, inductors, fuses, diodes, transformers, sensors, electrostatic discharge (ESD) devices, and memory devices.

In embodiments where the integrated circuit component 820 comprises multiple integrated circuit dies, they dies can be of the same type (a homogeneous multi-die integrated circuit component) or of two or more different types (a heterogeneous multi-die integrated circuit component). A multi-die integrated circuit component can be referred to as a multi-chip package (MCP) or multi-chip module (MCM).

In addition to comprising one or more processor units, the integrated circuit component 820 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate (such as Intel^{®} embedded multi-die interconnect bridges (EMIBs)), or combinations thereof.

Generally, the interposer 804 may spread connections to a wider pitch or reroute a connection to a different connection. For example, the interposer 804 may couple the integrated circuit component 820 to a set of ball grid array (BGA) conductive contacts of the coupling components 816 for coupling to the circuit board 802. In the embodiment illustrated in FIG. 8, the integrated circuit component 820 and the circuit board 802 are attached to opposing sides of the interposer 804; in other embodiments, the integrated circuit component 820 and the circuit board 802 may be attached to a same side of the interposer 804. In some embodiments, three or more components may be interconnected by way of the interposer 804.

In some embodiments, the interposer 804 may be formed as a PCB, including multiple metal layers separated from one another by layers of dielectric material and interconnected by electrically conductive vias. In some embodiments, the interposer 804 may be formed of an epoxy resin, a fiberglass-reinforced epoxy resin, an epoxy resin with inorganic fillers, a ceramic material, or a polymer material such as polyimide. In some embodiments, the interposer 804 may be formed of alternate rigid or flexible materials that may include the same materials described above for use in a semiconductor substrate, such as silicon, germanium, and other group III-V and group IV materials. The interposer 804 may include metal interconnects 808 and vias 810, including but not limited to through hole vias 810-1 (that extend from a first face 850 of the interposer 804 to a second face 854 of the interposer 804), blind vias 810-2 (that extend from the first or second faces 850 or 854 of the interposer 804 to an internal metal layer), and buried vias 810-3 (that connect internal metal layers).

In some embodiments, the interposer 804 can comprise a silicon interposer. Through silicon vias (TSV) extending through the silicon interposer can connect connections on a first face of a silicon interposer to an opposing second face of the silicon interposer. In some embodiments, an interposer 804 comprising a silicon interposer can further comprise one or more routing layers to route connections on a first face of the interposer 804 to an opposing second face of the interposer 804.

The interposer 804 may further include embedded devices 814, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 804. The package-on-interposer structure 836 may take the form of any of the package-on-interposer structures known in the art. In embodiments where the interposer is a non-printed circuit board

The integrated circuit device assembly 800 may include an integrated circuit component 824 coupled to the first face 840 of the circuit board 802 by coupling components 822. The coupling components 822 may take the form of any of the embodiments discussed above with reference to the coupling components 816, and the integrated circuit component 824 may take the form of any of the embodiments discussed above with reference to the integrated circuit component 820.

The integrated circuit device assembly 800 illustrated in FIG. 8 includes a package-on-package structure 834 coupled to the second face 842 of the circuit board 802 by coupling components 828. The package-on-package structure 834 may include an integrated circuit component 826 and an integrated circuit component 832 coupled together by coupling components 830 such that the integrated circuit component 826 is disposed between the circuit board 802 and the integrated circuit component 832. The coupling components 828 and 830 may take the form of any of the embodiments of the coupling components 816 discussed above, and the integrated circuit components 826 and 832 may take the form of any of the embodiments of the integrated circuit component 820 discussed above. The package-on-package structure 834 may be configured in accordance with any of the package-on-package structures known in the art.

FIG. 9 is a cross-sectional side view of an integrated circuit device 900 that may be included in any of the embodiments disclosed herein. One or more of the integrated circuit devices 900 may be included in one or more dies 702 (FIG. 7). The integrated circuit device 900 may be formed on a die substrate 902 (e.g., the wafer 700 of FIG. 7) and may be included in a die (e.g., the die 702 of FIG. 7). The die substrate 902 may be a semiconductor substrate composed of semiconductor material systems including, for example, n-type or p-type materials systems (or a combination of both). The die substrate 902 may include, for example, a crystalline substrate formed using a bulk silicon or a silicon-on-insulator (SOI) substructure. In some embodiments, the die substrate 902 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 902. Although a few examples of materials from which the die substrate 902 may be formed are described here, any material that may serve as a foundation for an integrated circuit device 900 may be used. The die substrate 902 may be part of a singulated die (e.g., the dies 702 of FIG. 7) or a wafer (e.g., the wafer 700 of FIG. 7).

The integrated circuit device 900 may include one or more device layers 904 disposed on the die substrate 902. The device layer 904 may include features of one or more transistors 940 (e.g., metal oxide semiconductor field-effect transistors (MOSFETs)) formed on the die substrate 902. The transistors 940 may include, for example, one or more source and/or drain (S/D) regions 920, a gate 922 to control current flow between the S/D regions 920, and one or more S/D contacts 924 to route electrical signals to/from the S/D regions 920. The transistors 940 may include additional features not depicted for the sake of clarity, such as device isolation regions, gate contacts, and the like. The transistors 940 are not limited to the type and configuration depicted in FIG. 9 and may include a wide variety of other types and configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon, nanosheet, or nanowire transistors.

Returning to FIG. 9, a transistor 940 may include a gate 922 formed of at least two layers, a gate dielectric and a gate electrode. The gate dielectric may include one layer or a stack of layers. The one or more layers may include silicon oxide, silicon dioxide, silicon carbide, and/or a high-k dielectric material.

The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor 940 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer.

For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 940 along the source-channel-drain direction, the gate electrode may consist of a U-shaped structure that includes a bottom portion substantially parallel to the surface of the die substrate 902 and two sidewall portions that are substantially perpendicular to the top surface of the die substrate 902. In other embodiments, at least one of the metal layers that form the gate electrode may simply be a planar layer that is substantially parallel to the top surface of the die substrate 902 and does not include sidewall portions substantially perpendicular to the top surface of the die substrate 902. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 920 may be formed within the die substrate 902 adjacent to the gate 922 of individual transistors 940. The S/D regions 920 may be formed using an implantation/diffusion process or an etching/deposition process, for example. In the former process, dopants such as boron, aluminum, antimony, phosphorous, or arsenic may be ion-implanted into the die substrate 902 to form the S/D regions 920. An annealing process that activates the dopants and causes them to diffuse farther into the die substrate 902 may follow the ion-implantation process. In the latter process, the die substrate 902 may first be etched to form recesses at the locations of the S/D regions 920. An epitaxial deposition process may then be carried out to fill the recesses with material that is used to fabricate the S/D regions 920. In some implementations, the S/D regions 920 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 920 may be formed using one or more alternate semiconductor materials such as germanium or a group III-V material or alloy. In further embodiments, one or more layers of metal and/or metal alloys may be used to form the S/D regions 920.

Electrical signals, such as power and/or input/output (I/O) signals, may be routed to and/or from the devices (e.g., transistors 940) of the device layer 904 through one or more interconnect layers disposed on the device layer 904 (illustrated in FIG. 9 as interconnect layers 906-910). For example, electrically conductive features of the device layer 904 (e.g., the gate 922 and the S/D contacts 924) may be electrically coupled with the interconnect structures 928 of the interconnect layers 906-910. The one or more interconnect layers 906-910 may form a metallization stack (also referred to as an "ILD stack") 919 of the integrated circuit device 900.

The interconnect structures 928 may be arranged within the interconnect layers 906-910 to route electrical signals according to a wide variety of designs; in particular, the arrangement is not limited to the particular configuration of interconnect structures 928 depicted in FIG. 9. Although a particular number of interconnect layers 906-910 is depicted in FIG. 9, embodiments of the present disclosure include integrated circuit devices having more or fewer interconnect layers than depicted.

In some embodiments, the interconnect structures 928 may include lines 928a and/or vias 928b filled with an electrically conductive material such as a metal. The lines 928a may be arranged to route electrical signals in a direction of a plane that is substantially parallel with a surface of the die substrate 902 upon which the device layer 904 is formed. For example, the lines 928a may route electrical signals in a direction in and out of the page and/or in a direction across the page from the perspective of FIG. 9. The vias 928b may be arranged to route electrical signals in a direction of a plane that is substantially perpendicular to the surface of the die substrate 902 upon which the device layer 904 is formed. In some embodiments, the vias 928b may electrically couple lines 928a of different interconnect layers 906-910 together.

The interconnect layers 906-910 may include a dielectric material 926 disposed between the interconnect structures 928, as shown in FIG. 9. In some embodiments, dielectric material 926 disposed between the interconnect structures 928 in different ones of the interconnect layers 906-910 may have different compositions; in other embodiments, the composition of the dielectric material 926 between different interconnect layers 906-910 may be the same. The device layer 904 may include a dielectric material 926 disposed between the transistors 940 and a bottom layer of the metallization stack as well. The dielectric material 926 included in the device layer 904 may have a different composition than the dielectric material 926 included in the interconnect layers 906-910; in other embodiments, the composition of the dielectric material 926 in the device layer 904 may be the same as a dielectric material 926 included in any one of the interconnect layers 906-910.

A first interconnect layer 906 (referred to as Metal 1 or "M1") may be formed directly on the device layer 904. In some embodiments, the first interconnect layer 906 may include lines 928a and/or vias 928b, as shown. The lines 928a of the first interconnect layer 906 may be coupled with contacts (e.g., the S/D contacts 924) of the device layer 904. The vias 928b of the first interconnect layer 906 may be coupled with the lines 928a of a second interconnect layer 908.

The second interconnect layer 908 (referred to as Metal 2 or "M2") may be formed directly on the first interconnect layer 906. In some embodiments, the second interconnect layer 908 may include via 928b to couple the interconnect structures 928 of the second interconnect layer 908 with the lines 928a of a third interconnect layer 910. Although the lines 928a and the vias 928b are structurally delineated with a line within individual interconnect layers for the sake of clarity, the lines 928a and the vias 928b may be structurally and/or materially contiguous (e.g., simultaneously filled during a dual-damascene process) in some embodiments.

The third interconnect layer 910 (referred to as Metal 3 or "M3") (and additional interconnect layers, as desired) may be formed in succession on the second interconnect layer 908 according to similar techniques and configurations described in connection with the second interconnect layer 908 or the first interconnect layer 906. In some embodiments, the interconnect layers that are "higher up" in the metallization stack 919 in the integrated circuit device 900 (i.e., farther away from the device layer 904) may be thicker that the interconnect layers that are lower in the metallization stack 919, with lines 928a and vias 928b in the higher interconnect layers being thicker than those in the lower interconnect layers.

The integrated circuit device 900 may include a solder resist material 934 (e.g., polyimide or similar material) and one or more conductive contacts 936 formed on the interconnect layers 906-910. In FIG. 9, the conductive contacts 936 are illustrated as taking the form of bond pads. The conductive contacts 936 may be electrically coupled with the interconnect structures 928 and configured to route the electrical signals of the transistor(s) 940 to external devices. For example, solder bonds may be formed on the one or more conductive contacts 936 to mechanically and/or electrically couple an integrated circuit die including the integrated circuit device 900 with another component (e.g., a printed circuit board or a package substrate, e.g., 112). The integrated circuit device 900 may include additional or alternate structures to route the electrical signals from the interconnect layers 906-910; for example, the conductive contacts 936 may include other analogous features (e.g., posts) that route the electrical signals to external components.

In some embodiments in which the integrated circuit device 900 is a double-sided die, the integrated circuit device 900 may include another metallization stack (not shown) on the opposite side of the device layer(s) 904. This metallization stack may include multiple interconnect layers as discussed above with reference to the interconnect layers 906-910, to provide conductive pathways (e.g., including conductive lines and vias) between the device layer(s) 904 and additional conductive contacts (not shown) on the opposite side of the integrated circuit device 900 from the conductive contacts 936.

In other embodiments in which the integrated circuit device 900 is a double-sided die, the integrated circuit device 900 may include one or more through silicon vias (TSVs) through the die substrate 902; these TSVs may make contact with the device layer(s) 904, and may provide conductive pathways between the device layer(s) 904 and additional conductive contacts (not shown) on the opposite side of the integrated circuit device 900 from the conductive contacts 936. In some embodiments, TSVs extending through the substrate can be used for routing power and ground signals from conductive contacts on the opposite side of the integrated circuit device 900 from the conductive contacts 936 to the transistors 940 and any other components integrated into the integrated circuit device 900, and the metallization stack 919 can be used to route I/O signals from the conductive contacts 936 to transistors 940 and any other components integrated into the integrated circuit device 900.

Multiple integrated circuit devices 900 may be stacked with one or more TSVs in the individual stacked devices providing connection between one of the devices to any of the other devices in the stack. For example, one or more high-bandwidth memory (HBM) integrated circuit dies can be stacked on top of a base integrated circuit die and TSVs in the HBM dies can provide connection between the individual HBM and the base integrated circuit die. Conductive contacts can provide additional connections between adjacent integrated circuit dies in the stack. In some embodiments, the conductive contacts can be fine-pitch solder bumps (microbumps).

FIG. 10 is a block diagram of an example electrical device 1000 that may include one or more of the embodiments disclosed herein. For example, any suitable ones of the components of the electrical device 1000 may include one or more of integrated circuit devices 900, or integrated circuit dies 702 disclosed herein. A number of components are illustrated in FIG. 10 as included in the electrical device 1000, but any one or more of these components may be omitted or duplicated, as suitable for the application. In some embodiments, some or all of the components included in the electrical device 1000 may be attached to one or more motherboards mainboards, or system boards. In some embodiments, one or more of these components are fabricated onto a single system-on-a-chip (SoC) die.

Additionally, in various embodiments, the electrical device 1000 may not include one or more of the components illustrated in FIG. 10, but the electrical device 1000 may include interface circuitry for coupling to the one or more components. For example, the electrical device 1000 may not include a display device 1006, but may include display device interface circuitry (e.g., a connector and driver circuitry) to which a display device 1006 may be coupled. In another set of examples, the electrical device 1000 may not include an audio input device 1024 or an audio output device 1008, but may include audio input or output device interface circuitry (e.g., connectors and supporting circuitry) to which an audio input device 1024 or audio output device 1008 may be coupled.

The electrical device 1000 may include one or more processor units 1002 (e.g., one or more processor units). As used herein, the terms "processor unit", "processing unit" or "processor" may refer to any device or portion of a device that processes electronic data from registers and/or memory to transform that electronic data into other electronic data that may be stored in registers and/or memory. The processor unit 1002 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

The electrical device 1000 may include a memory 1004, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 1004 may include memory that is located on the same integrated circuit die as the processor unit 1002. This memory may be used as cache memory (e.g., Level 1 (L1), Level 2 (L2), Level 3 (L3), Level 4 (L4), Last Level Cache (LLC)) and may include embedded dynamic random access memory (eDRAM) or spin transfer torque magnetic random access memory (STT-MRAM).

In some embodiments, the electrical device 1000 can comprise one or more processor units 1002 that are heterogeneous or asymmetric to another processor unit 1002 in the electrical device 1000. There can be a variety of differences between the processing units 1002 in a system in terms of a spectrum of metrics of merit including architectural, microarchitectural, thermal, power consumption characteristics, and the like. These differences can effectively manifest themselves as asymmetry and heterogeneity among the processor units 1002 in the electrical device 1000.

In some embodiments, the electrical device 1000 may include a communication component 1012 (e.g., one or more communication components). For example, the communication component 1012 can manage wireless communications for the transfer of data to and from the electrical device 1000. The term "wireless" and its derivatives may be used to describe circuits, devices, systems, methods, techniques, communications channels, etc., that may communicate data through the use of modulated electromagnetic radiation through a nonsolid medium. The term "wireless" does not imply that the associated devices do not contain any wires, although in some embodiments they might not.

The communication component 1012 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 1012 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 1012 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 1012 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 1012 may operate in accordance with other wireless protocols in other embodiments. The electrical device 1000 may include an antenna 1022 to facilitate wireless communications and/or to receive other wireless communications (such as AM or FM radio transmissions).

In some embodiments, the communication component 1012 may manage wired communications, such as electrical, optical, or any other suitable communication protocols (e.g., IEEE 802.3 Ethernet standards). As noted above, the communication component 1012 may include multiple communication components. For instance, a first communication component 1012 may be dedicated to shorter-range wireless communications such as Wi-Fi or Bluetooth, and a second communication component 1012 may be dedicated to longer-range wireless communications such as global positioning system (GPS), EDGE, GPRS, CDMA, WiMAX, LTE, EV-DO, or others. In some embodiments, a first communication component 1012 may be dedicated to wireless communications, and a second communication component 1012 may be dedicated to wired communications.

The electrical device 1000 may include battery/power circuitry 1014. The battery/power circuitry 1014 may include one or more energy storage devices (e.g., batteries or capacitors) and/or circuitry for coupling components of the electrical device 1000 to an energy source separate from the electrical device 1000 (e.g., AC line power).

The electrical device 1000 may include a display device 1006 (or corresponding interface circuitry, as discussed above). The display device 1006 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 1000 may include an audio output device 1008 (or corresponding interface circuitry, as discussed above). The audio output device 1008 may include any embedded or wired or wirelessly connected external device that generates an audible indicator, such speakers, headsets, or earbuds.

The electrical device 1000 may include an audio input device 1024 (or corresponding interface circuitry, as discussed above). The audio input device 1024 may include any embedded or wired or wirelessly connected device that generates a signal representative of a sound, such as microphones, microphone arrays, or digital instruments (e.g., instruments having a musical instrument digital interface (MIDI) output). The electrical device 1000 may include a Global Navigation Satellite System (GNSS) device 1018 (or corresponding interface circuitry, as discussed above), such as a Global Positioning System (GPS) device. The GNSS device 1018 may be in communication with a satellite-based system and may determine a geolocation of the electrical device 1000 based on information received from one or more GNSS satellites, as known in the art.

The electrical device 1000 may include another output device 1010 (or corresponding interface circuitry, as discussed above). Examples of the other output device 1010 may include an audio codec, a video codec, a printer, a wired or wireless transmitter for providing information to other devices, or an additional storage device.

The electrical device 1000 may include another input device 1020 (or corresponding interface circuitry, as discussed above). Examples of the other input device 1020 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 1000 may have any desired form factor, such as a hand-held or mobile electrical device (e.g., a cell phone, a smart phone, a mobile internet device, a music player, a tablet computer, a laptop computer, a 2-in-1 convertible computer, a portable all-in-one computer, a netbook computer, an ultrabook computer, a personal digital assistant (PDA), an ultra mobile personal computer, a portable gaming console, etc.), a desktop electrical device, a server, a rack-level computing solution (e.g., blade, tray or sled computing systems), a workstation or other networked computing component, a printer, a scanner, a monitor, a set-top box, an entertainment control unit, a stationary gaming console, smart television, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 1000 may be any other electronic device that processes data. In some embodiments, the electrical device 1000 may comprise multiple discrete physical components. Given the range of devices that the electrical device 1000 can be manifested as in various embodiments, in some embodiments, the electrical device 1000 can be referred to as a computing device or a computing system.

Illustrative examples of the technologies described throughout this disclosure are provided below. Embodiments of these technologies may include any one or more, and any combination of, the examples described below. In some embodiments, at least one of the systems or components set forth in one or more of the preceding figures may be configured to perform one or more operations, techniques, processes, and/or methods as set forth in the following examples.

Example 1 is an integrated circuit package comprising: a package substrate; a first integrated circuit die electrically coupled to the package substrate via wire bond connectors; a second integrated circuit die coupled to the package substrate; a heat spreader coupled to the first integrated circuit die via a thermal interface material (TIM); and a dielectric material encompassing the first integrated circuit die and the second integrated circuit die on the package substrate, wherein a top surface of the heat spreader is aligned with a top surface of the dielectric material.

Example 2 includes the subject matter of Example 1, wherein a width of the heat spreader is less than a width of the first integrated circuit die.

Example 3 includes the subject matter of Example 1, wherein at least a portion of the wire bond connectors have a portion thereof exposed at the top surface of the dielectric material.

Example 4 includes the subject matter of any one of Examples 1-3, wherein a top surface of the second integrated circuit die is aligned with the top surface of the dielectric material.

Example 5 includes the subject matter of any one of Examples 1-3, wherein the heat spreader is a first heat spreader, the TIM is a first TIM, and the integrated circuit package further comprises a second heat spreader coupled to the second integrated circuit die via a second TIM.

Example 6 includes the subject matter of Example 5, wherein a top surface of the second heat spreader is aligned with the top surface of the dielectric material.

Example 7 includes the subject matter of Example 5 or 6, wherein a width of the second heat spreader is less than or equal to a width of the second integrated circuit die.

Example 8 includes the subject matter of Example 5 or 6, wherein a width of the second heat spreader is greater than a width of the second integrated circuit die.

Example 9 includes the subject matter of any one of Examples 1-8, wherein the second integrated circuit die is coupled to the package substrate via solder-based electrical connections.

Example 10 includes the subject matter of any one of Examples 1-9, further comprising a thermally conductive material on the top surface of the dielectric material.

Example 11 includes the subject matter of Example 10, wherein the thermally conductive material is conformal to an outer surface of the integrated circuit package.

Example 12 is a computing system comprising: a circuit board; and an integrated circuit package coupled to the circuit board, the integrated circuit package according to any one of Examples 1-11.

Example 13 is a method comprising: depositing a first heat spreader on a first integrated circuit die of an integrated circuit package; depositing a second heat spreader on a second integrated circuit die of the integrated circuit package; depositing a dielectric mold material to encompass the first integrated circuit die and the second integrated circuit die on the integrated circuit package; removing material from a top surface of the integrated circuit package to expose the first heat spreader and the second heat spreader at the top surface of the integrated circuit package; and depositing a thermally conductive material on the top surface of the integrated circuit package.

Example 14 includes the subject matter of Example 13, wherein the thermally conductive material is deposited conformally on the integrated circuit package, e.g., using a sputtering process.

Example 15 includes the subject matter of Example 13 or 14, wherein the removing material from a top surface of the integrated circuit package is further to expose wire bond connectors that couple the first integrated circuit die to a package substrate of the integrated circuit package.

Example 16 includes the subject matter of any one of Examples 13-15, further comprising attaching a heat sink to the top surface of the integrated circuit package.

Example 17 includes the subject matter of any one of Examples 13-16, further comprising attaching the integrated circuit package to a circuit board.

In the above description, various aspects of the illustrative implementations have been described using terms commonly employed by those skilled in the art to convey the substance of their work to others skilled in the art. However, it will be apparent to those skilled in the art that the present disclosure may be practiced with only some of the described aspects. For purposes of explanation, specific numbers, materials, and configurations have been set forth to provide a thorough understanding of the illustrative implementations. However, it will be apparent to one skilled in the art that the present disclosure may be practiced without all of the specific details. In other instances, well-known features have been omitted or simplified in order not to obscure the illustrative implementations.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B and C). Additionally, it should be appreciated that items included in a list in the form of "at least one of A, B, and C" can mean (A); (B); (C); (A and B); (A and C); (B and C); or (A, B, and C). Similarly, items listed in the form of "at least one of A, B, or C" can mean (A); (B); (C); (A and B); (A and C); (B and C); or (A, B, and C).

The terms "over," "under," "between," "above," and "on" as used herein may refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening features.

The above description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

The term "coupled with," along with its derivatives, may be used herein. "Coupled" may mean one or more of the following. "Coupled" may mean that two or more elements are in direct physical or electrical contact. However, "coupled" may also mean that two or more elements indirectly contact each other, but yet still cooperate or interact with each other, and may mean that one or more other elements are coupled or connected between the elements that are said to be coupled with each other. The term "directly coupled" may mean that two or more elements are in direct contact. Further, "adjacent" may refer to layers or components that are in physical contact with each other. That is, there is no layer or component between the stated adjacent layers or components. For example, a layer X that is adjacent to a layer Y refers to a layer that is in physical contact with layer Y.

In various embodiments, the phrase "a first feature formed, deposited, or otherwise disposed on a second feature" may mean that the first feature is formed, deposited, or disposed over the second feature, and at least a part of the first feature may be in direct contact (e.g., direct physical and/or electrical contact) or indirect contact (e.g., having one or more other features between the first feature and the second feature) with at least a part of the second feature. Further, "located on" in the context of a first layer or component located on a second layer or component may refer to the first layer or component being directly physically attached to the second part or component (no layers or components between the first and second layers or components) or physically attached to the second layer or component with one or more intervening layers or components.

Where the disclosure recites "a" or "a first" element or the equivalent thereof, such disclosure includes one or more such elements, neither requiring nor excluding two or more such elements. Further, ordinal indicators (e.g., first, second, or third) for identified elements are used to distinguish between the elements, and do not indicate or imply a required or limited number of such elements, nor do they indicate a particular position or order of such elements unless otherwise specifically stated.

## Claims

1. An integrated circuit package comprising:
a package substrate;
a first integrated circuit die electrically coupled to the package substrate via wire bond connectors;
a second integrated circuit die coupled to the package substrate;
a heat spreader coupled to the first integrated circuit die via a thermal interface material (TIM); and
a dielectric material encompassing the first integrated circuit die and the second integrated circuit die on the package substrate, wherein a top surface of the heat spreader is aligned with a top surface of the dielectric material.

2. The integrated circuit package of claim 1, wherein at least a portion of the wire bond connectors have a portion thereof exposed at the top surface of the dielectric material.

3. The integrated circuit package of claim 1 or 2, wherein a top surface of the second integrated circuit die is aligned with the top surface of the dielectric material.

4. The integrated circuit package of claim 1 or 2, wherein the heat spreader is a first heat spreader, the TIM is a first TIM, and the integrated circuit package further comprises a second heat spreader coupled to the second integrated circuit die via a second TIM.

5. The integrated circuit package of claim 4, wherein a top surface of the second heat spreader is aligned with the top surface of the dielectric material.

6. The integrated circuit package of claim 4 or 5, wherein a width of the second heat spreader is less than or equal to a width of the second integrated circuit die.

7. The integrated circuit package of claim 4 or 5, wherein a width of the second heat spreader is greater than a width of the second integrated circuit die.

8. The integrated circuit package of any one of claims 1-7, wherein the second integrated circuit die is coupled to the package substrate via solder-based electrical connections.

9. The integrated circuit package of any one of claims 1-8, further comprising a thermally conductive material on the top surface of the dielectric material.

10. The integrated circuit package of claim 9, wherein the thermally conductive material is conformal to an outer surface of the integrated circuit package.

11. A computing system comprising:
a circuit board; and
an integrated circuit package according to any one of claims 1-10 coupled to the circuit board.

12. A method comprising:
depositing a first heat spreader on a first integrated circuit die of an integrated circuit package;
depositing a second heat spreader on a second integrated circuit die of the integrated circuit package;
depositing a dielectric mold material to encompass the first integrated circuit die and the second integrated circuit die on the integrated circuit package;
removing material from a top surface of the integrated circuit package to expose the first heat spreader and the second heat spreader at the top surface of the integrated circuit package; and
depositing a thermally conductive material on the top surface of the integrated circuit package.

13. The method of claim 12, wherein the thermally conductive material is deposited conformally on the integrated circuit package.

14. The method of claim 13, wherein the thermally conductive material is deposited using a sputtering process.

15. The method of any one of claims 12-14, wherein the removing material from a top surface of the integrated circuit package is further to expose wire bond connectors that couple the first integrated circuit die to a package substrate of the integrated circuit package.
